# EUROPEAN PATENT APPLICATION

(11) **EP 4 844 431 A1**
(43) Date of publication of application: **25.11.2026**
(21) Application number: 25275037.7
(22) Date of filing: 20.05.2025
(51) Int. Cl.: G01R 33/421

(54) **SHIELD STRUCTURE AND MAGNETIC RESONANCE DEVICE**

(71) Applicant: Siemens Healthcare Limited, Camberley, Surrey GU15 3YL (GB)
(72) Inventor: BROWN, Samuel, Oxford, OX2 9DW (GB); WALTON, Philip, Witney, Oxon, OX28 5NL (GB)
(74) Representative: Siemens Healthineers Patent Attorneys

(57) **Abstract**

The invention relates to a shield structure (30) for shielding a component from a magnetic field, the shield structure (30) comprising: a plurality of layers (31) of a magnetic shielding material arranged in a stacked configuration; a gap (43) separating adjacent layers (31) of the plurality of layers (31); and a spacing element (60) configured to maintain the gap (43) between the adjacent layers (31). The current invention further concerns a magnetic resonance device (10) configured to acquire magnetic resonance data from an object (15) positioned in an imaging region (14) of the magnetic resonance device (10), comprising: a magnet arrangement (11) configured to generate a magnetic field; and an inventive shield structure (30) configured to shield at least one component of the magnetic resonance device (10) from the magnetic field.

## Description

Independent of the grammatical term usage, individuals with male, female or other gender identities are included within the term.

The current invention relates to a shield structure for shielding a component from a magnetic field and a magnetic resonance device comprising such a shield structure.

Magnetic resonance devices are widely used in medical imaging to obtain detailed images of internal body structures. These devices typically employ magnetic fields to align the nuclear spins of atoms within the body, and then use radiofrequency pulses to manipulate these spins and generate detectable signals. The quality and resolution of the resulting images depend on various factors, including the strength and uniformity of the magnetic field.

In magnetic resonance devices, certain components are sensitive to magnetic fields and can be adversely affected by exposure to strong magnetic fields. For example, motors, electronic circuits, transformers, and switches used in various subsystems of the magnetic resonance device may experience interference or malfunction when subjected to intense magnetic fields. This can lead to reduced performance, increased maintenance requirements, or even failure of critical components.

Conventional approaches to protecting sensitive components from magnetic fields often involve the use of shielding structures made of ferromagnetic materials. While these structures can provide some level of protection, they may not offer sufficient shielding effectiveness in high-field environments. Furthermore, conventional shielding structures can be heavy and costly, especially when higher shielding efficiencies are desired.

Another challenge with conventional shielding structures is the difficulty in manufacturing and assembling the shield structures. Welded joints, which are commonly used in conventional designs, can be time-consuming to produce and may introduce inconsistencies in the shielding effectiveness. Furthermore, welded structures can be challenging to disassemble for maintenance or modification.

The weight of the shielding structure is an additional concern, particularly in applications where overall system weight is a critical factor. Heavier shield structures can complicate installation, increase stress on supporting structures, and potentially impact the mobility of the magnetic resonance device.

Hence, it is an object of the current invention to provide a shield structure for shielding a component from a magnetic field that overcomes one or more of the above-mentioned problems.

This object is achieved by a shield structure and a magnetic resonance device according to the independent claims. Further advantageous embodiments are specified in the dependent claims.

In a first aspect, the invention concerns a shield structure for shielding a component from a magnetic field. The shield structure comprises a plurality of layers of a magnetic shielding material arranged in a stacked configuration. A gap separates adjacent layers of the plurality of layers. The shield structure comprises a spacing element configured to maintain the gap between the adjacent layers.

A shield structure can be configured to shield a component from a magnetic field. For example, the shield structure may be configured to reduce an impact of an external magnet field on the component to be shielded. The component to be shielded may be accommodated and/or enclosed within a receiving space of the shield structure. According to an embodiment, the shield structure is configured to reduce a strength of a magnetic field inside the receiving space in comparison to a strength of a magnetic field of an external magnetic field surrounding the shield structure. In some embodiments, the shield structure may be configured to enclose a magnet or magnet arrangement generating the magnetic field and the component to be shielded may be arranged outside a volume enclosed by the shield structure. For example, the shield structure may be configured as a shield structure of an examination room comprising a magnetic resonance device. In other embodiments, the shield structure may be arranged within the magnetic field generated by a magnet or magnet arrangement and configured to at least partially enclose the component to be shielded from the magnetic field. The term magnetic field may refer to any magnetic or electromagnetic field generated by a magnet, such as a permanent magnet, an electromagnet, or a superconducting magnet.

A layer may represent a thin sheet or film of material. The layer may comprise or consist of a sheet or film of magnetic shielding material. The magnetic shielding material can be a material that is configured to attenuate or redirect magnetic fields. Examples of magnetic shielding materials can include, but are not limited to, magnetic or ferromagnetic materials. Ferromagnetic materials can exhibit strong magnetic properties and can be effective at redirecting magnetic field lines. Examples of ferromagnetic materials suitable for use in the shield structure can include iron, nickel, cobalt, and their alloys.

The plurality of layers can comprise or consist of sheets or layers of metal. For example, the plurality of layers can comprise or consist of punched or laser-cut sheet metal. It is also conceivable that the plurality of layers comprises or consists of a cast material, a sintered material, or a material or structure obtained via an additive manufacturing method (e. g. 3D printing). In certain embodiments, the plurality of layers comprises folded sheet metal, depending on a geometry of the component to be shielded. According to an embodiment, the plurality of layers can be made of iron, mild steel, or other ferromagnetic materials. The plurality of layers may consist of a material with low magnetic reluctance. Different layers of the plurality of layers may comprise or consist of different materials or different material compositions. A thickness of each layer of the plurality of layers can be, for example, between 0.5 mm and 5 mm, or between 1 mm and 3 mm. The shield structure can comprise two or more layers of the magnetic shielding material.

The shield structure may comprise a gap separating adjacent layers of the plurality of layers. The gap can be defined as a space or interval between two objects or points. In the context of the shield structure, a gap may represent a space between adjacent layers. A width of the gap between adjacent layers can be, for example, between 0.5 mm and 5 mm, or between 1 mm and 3 mm. The width of the gap can be determined based on various factors, such as the strength of the magnetic field to be shielded, the material properties and/or dimensions of the plurality of layers, and the overall size and shape of the shield structure. A spacing element according to an embodiment described below can be used to maintain a desired width of the gap between the adjacent layers.

The gap between the adjacent layers can serve various purposes in the shield structure. For example, the gap may enhance the shielding effectiveness of the shield structure by creating additional interfaces for magnetic field attenuation and/or redirection. Moreover, the gap may allow for thermal expansion of the layers without causing structural stress.

The term adjacent layers may refer to at least two layers of the plurality of layers that are positioned next to each other, with a gap or spacing element separating them. In certain embodiments, adjacent layers may be held together or mechanically connected via a connecting element. It is conceivable that two, three or more layers of the plurality of layers represent adjacent layers held together by a connecting element. The shield structure may comprise one or more pairs of adjacent layers, which can be arranged in a stacked configuration.

The gap between the adjacent layers may comprise a vacuum. In other examples, the gap between adjacent layers can be at least partially filled or occupied by a fluid, a plastic, or any material having a high magnetic reluctance. According to an embodiment, the gap between the adjacent layers is at least partially filled or occupied by a material that is configured to maintain the gap between the adjacent layers and/or provide structural stability to the plurality of layers.

The spacing element may comprise or consist of a material having a high magnetic reluctance. The spacing element can be configured to provide a consistent separation between the adjacent layers. It is conceivable that the spacing element is configured to mechanically support the adjacent layers and/or prevent the adjacent layers from collapsing and/or deforming.

According to an embodiment, the shield structure can incorporate a plastic material or resin between the plurality of layers. The resin may provide improved structural integrity, stability and/or shielding performance of the shielding structure. For example, the shield structure can be submersed in a resin, allowing the resin to fill the gaps between the plurality of layers. Alternatively or additionally, a conduit may be used through which resin can be filled into one or more gaps between the plurality of layers.

The stacked configuration of the plurality of layers may represent or be understood as a laminated structure or a shell structure comprising a plurality of concentrically arranged shells or layers. For example, the plurality of layers may be stacked concentrically and/or on top of each other with gaps provided between each pair of adjacent layers. The plurality of layers may be arranged in a parallel, overlapping manner. The stacked configuration of the plurality of layers can enhance the shielding effectiveness of the shield structure compared to a single thick layer of magnetic shielding material. In providing a plurality of layers of a magnetic shielding material separated by gaps, multiple interfaces may be provided, which can help to attenuate and/or redirect magnetic field lines.

The shield structure can be configured to shield various components from magnetic fields in different applications. For example, the shield structure can be configured to shield a motor, a switch, a sensor, a fan, a loudspeaker, an electronic circuit, a cable, a transformer, an amplifier, an inductor and/or other sensitive instruments exposed to magnetic fields.

The shield structure may favourably allow for scalability. For example, the number of layers in the shield structure can be expanded or reduced depending on the specific shielding requirements and cost considerations, potentially enabling the shield structure to be adapted for different applications with varying magnetic field strengths and/or shielding requirements.

The shield structure can be used in various applications where magnetic shielding is required. For example, the shield structure can be implemented in magnetic resonance devices, particle accelerators, fusion reactors, or magnetic levitation systems. These applications often involve strong magnetic fields that can interfere with sensitive components or equipment.

Moreover, the shield structure can be designed for ease of assembly and disassembly. For example, the shield structure may comprise easy access fasteners or connecting elements that enable quick and/or convenient assembly or disassembly, potentially facilitating maintenance, repairs, or modifications to the shielded component and/or the shield structure itself.

The shield structure according to the invention can provide several technical advantages. For example, the scalable design may allow for optimization of shielding performance and/or cost for specific applications. The option to incorporate a plastic material, a resin, or another spacing element within the gap can enhance structural integrity and potentially improve shielding effectiveness. Moreover, the shield structure may require lower amounts of a magnetic shielding material compared to conventional shield structures, potentially reducing costs and/or weight. The improved shielding efficiency may also allow for components to be arranged differently within the magnetic field in comparison to conventional shield structure, providing more freedom in the design of magnetic systems. The provision of a spacing element may facilitate assembly and/or disassembly of the shield structure, but also reduce maintenance time and/or costs associated with accessing shielded components. Furthermore, the use of sheet metal and spacing elements can also improve manufacturability and geometric accuracy of the shield structure.

According to an embodiment of the inventive shield structure, the plurality of layers comprises a first layer, a second layer, and a third layer. A first gap may be provided between the first layer and the second layer. A second gap may be provided between the second layer and the third layer.

The shield structure can comprise a plurality of layers of a magnetic shielding material arranged in a stacked configuration. The plurality of layers can comprise at least three layers, for example a first layer, a second layer, and a third layer. According to an embodiment, the plurality of layers of the shield structure comprises more than three layers.

The shield structure may comprise a plurality of gaps. For example, each pair of adjacent layers of the plurality of layers may be separated by a gap according to an embodiment described above. The shield structure can comprise one or more spacing elements configured to maintain the gaps between each pair of adjacent layers.

According to an embodiment, a dimension of the first gap corresponds to a dimension of the second gap. In a further embodiment, a dimension of the first gap differs from a dimension of the second gap. For example, a distance between two adjacent layers separated by the first gap may correspond to or deviate from a distance between two adjacent layers separated by the second gap. A shield structure comprising gaps with different dimensions may allow for a tailoring of the shielding effect provided by different layers or sections of the shield structure. Thus, a shape of the shield structure and/or a material use may be optimized for certain applications and/or a shape of the component to be shielded.

A plurality of layers separated by one or more gaps can provide enhanced magnetic shielding compared to a single layer. In providing a laminated structure comprising gaps between layers of magnetic shielding material, an improved or optimized magnetic flux path may be created that more effectively redistributes the magnetic field around the component to be shielded.

A shield structure according to the invention comprising two or more layers with gaps provided between each pair of adjacent layers may favourably provide superior shielding effectiveness and/or reduce the overall weight and material costs compared to conventional shield structures or shield structures comprising a lower number of layers.

In a further embodiment of the inventive shield structure, the spacing element comprises as at least one of:
- a dimple formed on at least one of the plurality of layers;
- a louver formed on at least one of the plurality of layers;
- a spacer arranged between at least two layers of the plurality of layers; or
- a self-clinching insert arranged between at least two layers of the plurality of layers.

A spacing element can be configured to maintain a consistent gap or distance between adjacent layers of the shield structure. The spacing element may be configured to mechanically couple and/or directly connect the adjacent layers. It is conceivable that the gap or distance between the adjacent layers substantially corresponds to a dimension of the spacing element. For example, a width of the gap may substantially coincide with a dimension of the spacing element. A consistent spacing of adjacent layers may favourably contribute to the overall shielding effectiveness of the shield structure.

A dimple can be configured as a small protrusion or indentation formed on at least one layer of the plurality of layers. The dimple can be formed by pressing, stamping or otherwise deforming a portion of the at least one layer to create a raised or depressed area. The dimple can be configured to create a predetermined spacing between adjacent layers when the layers are stacked together. Dimples can help maintain consistent spacing between one or more layers while allowing for a compact overall structure.

A louver can be configured as an angled protrusion or flap formed on at least one layer of the plurality of layers. The louver can be created by cutting and bending a portion of the layer material. Louvers can provide spacing while also potentially improving airflow or heat dissipation between layers. A louver may also provide an opening through which resin can be filled into the spaces between the layers, potentially facilitating a process of filling resin into the gap between adjacent layers.

A dimple and/or a louver may be provided on a surface of the at least one layer. It is conceivable that a dimple and/or a louver are formed in the material of the at least one layer. The shield structure may comprise multiple dimples and/or louvers arranged in a regular or irregular pattern across the surface of one or more layers of the plurality of layers to provide consistent spacing throughout the shield structure.

A spacer can be configured as a separate component arranged between at least two layers of the plurality of layers. The spacer can be made of various materials and shaped to provide consistent spacing between the at least two layers. Examples of spacers include washers, bushings, or custom-shaped components. The spacer may comprise or consist of a non-magnetic material having a high magnetic reluctance such as plastics, ceramics or composite materials (e. g. glass reinforced resin or glass reinforced carbon). In some embodiments, the spacer may comprise or consist of a metal, such as steel or stainless steel. The shield structure may comprise multiple spacers positioned at strategic points between adjacent layers to provide consistent spacing while minimizing the overall number of components.

A self-clinching insert can be configured as a threaded or unthreaded fastener that can be pressed into a hole in the at least one layer and protrude from a surface of the at least one layer to provide spacing to an adjacent layer. The self-clinching insert may comprise an opening or bore configured to accommodate a bolt, pin, or other connecting element configured to deform the self-clinching insert upon insertion. Self-clinching inserts can provide both spacing and attachment functions in a compact form.

The spacing element can be configured as a dimple, a louver, a spacer, or a self-clinching insert according to an embodiment described above. The spacing element may be configured to maintaining a consistent gap between adjacent layers of the shield structure, which can enhance the overall shielding effectiveness. By using various types of spacing elements, the shield structure can be optimized for different applications, manufacturing processes, or target manufacturing costs. The spacing elements may be arranged in a regular or irregular pattern throughout the shield structure.

The spacing element may be configured to accommodate a connecting element. For example, the spacing element may comprise a hole, opening, or bore configured to receive or accommodate a rivet, a pin, a screw, a bolt, or the like.

The use of a spacing element to maintain the gap between the adjacent layers may favourably contribute to weight reduction in the shield structure compared to solid or single layer shield structures. Moreover, the use of a spacing element according to an embodiment described above may favourably allow for the shield structure to be assembled and disassembled more easily compared to a welded or permanently bonded shield structure, potentially facilitating maintenance, repairs, and/or modifications to the shield structure or the shielded component.

In a further embodiment of the inventive shield structure, the spacing element comprises a material having a high magnetic reluctance.

A material with high magnetic reluctance can be characterized by its resistance to magnetic flux. Materials with high magnetic reluctance can impede the flow of magnetic fields through them. Examples of materials with high magnetic reluctance can include plastics (e. g., various types of plastics, such as polyethylene, polypropylene, or polyvinyl chloride, or the like), ceramics, composite materials, diamagnetic materials (e. g., bismuth) and some non-ferromagnetic metals (e. g., copper, aluminium, brass, or the like). These materials can provide structural support while providing a resistance to magnetic flux and/or diverting magnetic flux along a trajectory defined by the plurality of layers.

A spacing element comprising a material having a high magnetic reluctance can enhance the shielding effectiveness of the shield structure. By using a material having a high magnetic reluctance for the spacing element, magnetic flux can be more effectively directed along a material of the plurality of layers and/or impeded from penetrating through the plurality of layers of the shield structure. Thus, a spacing element comprising a material having a high magnetic reluctance may synergistically complement the low magnetic reluctance properties of the magnetic shielding layers, potentially resulting in improved shielding performance compared to a conventional shield structure or a shield structure without such spacing elements.

A spacing element comprising a material with high magnetic reluctance can be configured in various forms, such as a solid spacer made of a non-magnetic material, a hollow spacer (filled at least partially with air or another fluid), a coating, a film, or a lamination applied to the surface of at least one layer of the plurality of layers. The spacing element may also be configured as a foam or cellular material, e. g. comprising a high proportion of air or gas content.

The use of a spacing element comprising a material with high magnetic reluctance can provide several advantages. For example, the spacing element may impede or resist magnetic flux, encouraging the magnetic flux to travel through the magnetic shielding material of the plurality of layers rather than through the spacing element. Thus, the use of a spacing element comprising a material with high magnetic reluctance can enhance the overall shielding effectiveness of the shield structure by promoting the desired path for magnetic flux through the plurality of layers.

Moreover, the spacing element can help maintain separation between adjacent layers of magnetic shielding material, preventing direct contact that could potentially create a path for magnetic flux to bypass the plurality of layers. The spacing elements may favourably improve a structural integrity and shielding effectiveness of the shielding structure.

Additionally, the use of spacing elements comprising a material with high magnetic reluctance may contribute to weight reduction in the overall shield structure, as such materials are typically lighter than ferromagnetic materials used for magnetic shielding.

Additionally or alternatively, the spacing element can comprise a material having a low magnetic reluctance. A material having a low magnetic reluctance can be characterized by a low resistance to the passage of magnetic flux. Materials with high magnetic reluctance can be configured to impede or reduce a magnetic flux to pass through them, while materials with low magnetic reluctance can be configured to allow for the magnetic flux to pass through them.

According to a further embodiment, the inventive shield structure comprises a connecting element configured to mechanically connect the adjacent layers.

A connecting element can be configured to provide a physical attachment or fastening between two or more layers of the plurality of layers. The connecting element can be configured to maintain the structural integrity of the shield structure by holding two or more layers of the plurality of layers together in an intended spatial arrangement. For example, the connecting element may be configured to mechanically connect or attach at least one layer of the plurality of layers to one or more layers of the plurality of layers.

According to an embodiment, the connecting element is configured to attach or secure the spacing element in an intended position between two adjacent layers. The connecting element may be configured to mechanically engage with the spacing element, but also one or more layers of the plurality of layers, to provide a form-locking connection, a force-locking connection and/or a material connection between the one or more layers, but also the spacing element.

The connecting element can comprise various types of fasteners or attachment mechanisms. For example, the connecting element can be configured as a rivet, a pin, a screw, or a bolt. In other examples, the connecting element may comprise a clamp, a thread, a plug, a clip, an adhesive joint, a solder joint, a welded joint, or the like.

The connecting element can be configured to pass through corresponding holes provided in the adjacent layers, but also the spacing element, to mechanically connect the adjacent layers. The connecting element may be configured to ensure that the adjacent layers remain in a predefined spatial arrangement relative to one another, but also to the shield structure. The corresponding holes provided in the adjacent layers, but also the spacing element, may represent connecting points at which the plurality of layers are attached or held together.

A connecting element may favourably allow for the shield structure to maintain its structural integrity and desired layer separation even under mechanical stress or vibration. The connecting element may also facilitate assembly and/or disassembly of the shield structure.

The connecting element may comprise or consist of a material compatible with the magnetic shielding requirements of the shield structure. For instance, the connecting element can be fabricated from one of the non-magnetic materials (e. g., a material having a high magnetic reluctance) mentioned above to avoid interfering with the shielding function of the plurality of layers. Alternatively, the connecting element can be made from a material having a low magnetic reluctance if a potentially increased magnetic flux at the connection points is desired or can be tolerated.

The shield structure may comprise a plurality of connecting elements. The size, number, and placement of the connecting elements can be optimized based on the specific requirements of the shield structure. For example, larger shield structures may require more connecting elements or connecting elements with greater strength to maintain a desired spatial arrangement of the plurality of layers.

A connecting element configured to mechanically connect the adjacent layers may favourably allow for a robust and/or adjustable shield structure. The connecting element can allow for precise control over the width of the gap between layers, which can be crucial for optimizing the shielding effectiveness of the shield structure. Additionally, the connecting element may be configured to allow for disassembly and reassembly of the shield structure, potentially facilitating maintenance, upgrades, and/or modifications to the shielded components without requiring complete replacement of the shield structure.

In a further embodiment of the inventive shield structure, the connecting element comprises at least one of: a rivet; a pin; a screw; or a bolt. The connecting element can be configured to pass through corresponding holes in the spacing element and in the adjacent layers to mechanically connect the adjacent layers.

A rivet can comprise a cylindrical shaft with a head on one or both ends. The rivet can be inserted through aligned holes in one or more spacing elements and in two or more layers of the plurality of layers to be connected. The rivet may comprise a plain end which can be deformed or "compressed" to create a second head, securing the layers together. Rivets can provide a permanent connection between the two or more layers. Rivets can provide a strong, reliable connection between the plurality of layers while maintaining a desired spacing in conjunction with the spacing element.

A pin can be configured as a cylindrical or tapered piece used to fasten or align components. The pin can be inserted through corresponding holes in two or more layers of the plurality of layers and in one or more spacing elements of the shield structure. Pins can be secured in place by a friction fit, an adhesive, and/or a mechanical deformation of the pin ends. Pins can allow for easier disassembly compared to rivets while still providing a secure connection.

A screw can comprise a cylindrical shaft with a helical thread on its surface and typically a head on one end. The screw can be inserted through aligned holes in two or more layers of the plurality of layers and in one or more spacing elements. The screw may be rotated to engage with a threaded hole or nut, drawing the two or more layers together and sandwiching the one or more spacing elements. Screws can allow for adjustable tightness and for disassembly and reassembly of the shield structure if needed.

A bolt can be similar to a screw but is typically used in conjunction with a separate nut. The bolt can be inserted through aligned holes in one or more spacing elements and in two or more layers of the plurality of layers. A nut can be threaded onto the protruding end to secure the two or more layers together. Bolts can provide high strength connections and allow for easy disassembly.

The connecting element can be configured to pass through corresponding holes in the spacing element and in the adjacent layers to mechanically connect the adjacent layers. The connecting element may be configured to securely fasten two or more layers and one or more spacing elements together, maintaining the desired spacing between the two or more layers while providing structural integrity to the shield structure. According to an embodiment, the connecting element is configured to ensure that the spacing element maintains a predetermined position relative to the adjacent layers. The corresponding holes in the two or more layers and in the one or more spacing elements can be aligned during assembly to allow for proper insertion of the connecting element. The size and shape of the holes can be selected to accommodate the specific type of connecting element used.

In certain embodiments, the connecting element can be made of a non-magnetic material to avoid interfering with the shielding properties of the shield structure.

The use of a connecting element to mechanically secure a spacing element between adjacent layers can provide several technical advantages. For example, the connecting element and the spacing element can ensure a consistent spacing between layers, which can be critical for optimal shielding performance. Furthermore, a plurality of connecting elements may improve the structural integrity and durability of the shield structure by attaching adjacent layers together at a plurality of connecting points. Additionally, the use of removable connecting elements like screws or bolts can allow for easy maintenance, repair, or reconfiguration of the shield structure and/or the component to be shielded.

According to a further embodiment of the inventive shield structure, the gap between the adjacent layers comprises a fluid or a vacuum.

The gap between the adjacent layers can be occupied or filled by a fluid. A fluid can be configured as a gas or a liquid. Examples of gases that can be used to fill the gap between the adjacent layers include air, nitrogen, helium, argon, or other inert gases. In some implementations, the fluid can be a liquid with high magnetic reluctance and/or low electrical conductivity, such as water or certain oils. In certain embodiments, the liquid may be a non-conductive liquid. In case the gap between the adjacent layers comprises water, the adjacent layers can be zinc plated or powder coated to improve corrosion resistance.

Air and many other gasses have a high magnetic reluctance compared to ferromagnetic materials commonly used in magnetic shielding. The fluid within the gap created by the spacing element can act as a barrier to magnetic flux, forcing or encouraging the magnetic flux to travel through the more magnetically permeable plurality of layers of magnetic shielding material.

In some examples, the gap between the adjacent layers may comprise a vacuum. A vacuum can be characterized by an extremely low density of particles or molecules. The vacuum can be a partial vacuum or a high vacuum, depending on the degree of evacuation. A vacuum may be characterized by high magnetic reluctance. The vacuum may also provide excellent insulation properties, minimizing potential heat transfer between the adjacent layers. The vacuum in the gap can be created and maintained using various vacuum technologies, such as vacuum pumps or sealed vacuum chambers.

The gap between the adjacent layers can be at least partially filled with one or more spacing elements to provide additional structural stability and/or enhance the shielding properties. For example, the gap can be occupied with one or more spacing elements or spacers according to a previously described embodiment. The spacing elements or spacers can be configured to maintain the spacing between the adjacent layers while contributing to the overall rigidity of the shield structure. In certain embodiments, the spacing elements or spacers may comprise hollow or foam-like structures which are filled with a fluid, potentially providing a high magnetic reluctance and/or reducing weight of the shield structure.

By providing a gap between adjacent layers comprising a fluid or a vacuum, an overall shielding performance of the shield structure may favourably be enhanced. The fluid or vacuum within the gap may create discontinuities in the magnetic field path, which can help to attenuate and redirect the magnetic field. Thus, a shielding efficiency of the shield structure may be improved compared to solid or single-layer designs, while potentially reducing the overall weight and material costs of the shield structure.

In a further embodiment of the inventive shield structure, a layer of the shield structure comprises at least one protruding element protruding from a surface of the shield structure. The protruding element can be configured to mechanically connect the shield structure to a support structure.

At least one layer of the plurality of layers of the shield structure may comprise at least one protruding element protruding from a surface of the shield structure. The at least one layer comprising the at least one protruding element may represent an outer layer or a middle layer (e. g. a layer arranged between two layers) of the shield structure.

A protruding element can be configured as a section of material that extends outward from a main body or surface of the shield structure. The at least one protruding element can be formed as an integral part of one of the layers of the shield structure. For example, the at least one protruding element may represent a portion of the at least one layer that extends beyond edges of the other layers. Alternatively, the at least one protruding element can be configured as a separate component that is attached to one or more of the layers via a suitable mechanical connection.

The at least one protruding element can be configured in various shapes and sizes depending on the specific application and a design of the support structure. For example, the at least one protruding element can be configured as a tab, flange, bracket, or hook. The at least one protruding element can comprise one or more holes or slots to facilitate attachment to the support structure using fasteners such as screws, bolts, or rivets.

The at least one protruding element can be configured to provide a point of attachment between the shield structure and another component or support structure. This mechanical connection can enable the shield structure to be securely mounted or positioned within a larger assembly or device.

A support structure may represent a component or framework designed to hold, secure, or stabilize the shield structure. Examples of support structures can include mounting brackets, frames, housings, or dedicated attachment points on a larger device or system. The support structure can be configured to maintain the shield structure in a desired position or orientation. For example, in a magnetic resonance device, the support structure can be an outer vacuum chamber, a turret, a gradient coil support structure, or a patient table. In other applications, the support structure can be a frame, chassis, or housing of the device or system requiring magnetic shielding.

The at least one protruding element may be configured to mechanically connect the shield structure to a support structure by means of various fastening mechanisms. These fastening mechanisms can include, but are not limited to, bolting, screwing, welding, soldering, glueing, riveting, snap-fitting, plugging, or clamping. The specific fastening mechanism can be selected based on factors such as the materials involved, the required strength of the connection, and the need for potential disassembly.

The at least one protruding element can be configured to provide additional functions beyond mechanical connection. For example, the protruding element can be configured to aid in alignment during assembly, to provide a thermal conduction path, and/or to serve as an electrical grounding point.

The at least one protruding element can also be configured to provide additional shielding effectiveness. For example, the protruding element can be shaped or oriented in such a way as to extend the shielding effect beyond the main body of the shield structure, potentially closing gaps or weak points in the overall shield structure and/or to provide a desired orientation or angle of the shield structure to a main direction of the magnetic field.

In some embodiments, multiple protruding elements can be provided on different surfaces or edges of the shield structure, potentially allowing for more secure attachment and/or better distribution of mechanical loads. The number, size, and placement of the protruding elements can be optimized based on the specific shielding requirements, mechanical constraints, and assembly considerations of the particular application.

A shield structure comprising at least one protruding element may favourably provide a secure and flexible means of attaching the shield structure to a support structure. The at least one protruding element may favourably facilitate a process of arranging the shield structure relative to the component being shielded and/or the support structure, but also improve shielding performance of the shield structure. Moreover, the at least one protruding element can facilitate assembly and disassembly of the shield structure, favourably providing time and/or cost savings. Additionally, the protruding element can enable the use of the shield structure in a wide range of applications, enhancing its versatility and potential applications.

In a further embodiment, the inventive shield structure comprises a first section and a second section. The first section and the second section can be configured to be mechanically connected to form an enclosure for the component to be shielded.

A section of the shield structure can be configured as a portion or segment of the shield structure. The first section and second section can be configured as complementary halves or parts that, when joined together, form a complete enclosure or housing around the component to be shielded.

The first section and the second section may be attached or secured to one another via a mechanical connection. The mechanical connection may comprise various fastening means. Examples of such fastening means include but are not limited to: bolts and nuts, screws, rivets, clips, clamps, latches, interlocking elements, or the like. The mechanical connection may allow for the first section and the second section to be securely attached while facilitating maintenance as well as assembly and/or disassembly of the shield structure and/or the shielded component.

The enclosure formed by connecting the first section and the second section (and optionally a further section) can be configured as a structure or hull that surrounds or envelops the component to be shielded. The enclosure may provide a confined space around the component. A shape of the enclosure can be matched with or adapted to a shape of the component to be shielded to save space and/or to improve the shielding performance of the shield structure. It is conceivable that the enclosure surrounds the component to be shielded from multiple sides. For example, the enclosure formed by the shield structure may be configured to circumferentially enclose the component to be shielded along a primary axis or longitudinal axis of the component to be shielded. A customized shaping of the enclosure may ensure a close fit between the shield structure and the component, which can enhance the overall shielding performance and/or reduce the footprint of the shield structure. By enclosing the component along its circumferential direction, the shield structure can provide a more uniform and comprehensive shielding effect.

The enclosure formed by the first section and the second section of the shield structure may define or correspond to a receiving space. The receiving space can be configured to accommodate the component to be shielded.

The component to be shielded may represent any device, part, or assembly that requires protection from (electro-)magnetic fields. Examples of components that may require shielding include motors, switches, electronic circuits, fans, loudspeakers, cables, amplifiers, transformers, inductors, sensors, or other (electro-)magnetic field-sensitive equipment.

A shield structure forming an enclosure may favourably provide (electro-)magnetic shielding for the component to be shielded from multiple sides or different directions, improving the overall shielding effectiveness compared to partial shielding approaches.

The modular design of a shield structure comprising two or more sections configured to be mechanically connected to form an enclosure for the component to be shielded may favourably facilitate assembly, disassembly, and/or maintenance of the shield structure or the component to be shielded, as the shield structure can be opened and closed around the component. Furthermore, a close-fitting nature of the enclosure provided by the shielded structure can minimize spatial requirements and/or weight of the shield structure.

In a further embodiment of the inventive shield structure, a layer of the first section comprises a first protruding element, and a layer of the second section comprises a second protruding element. The first protruding element and the second protruding element can protrude from a surface of the shield structure. The first protruding element and the second protruding element can be configured to attach the first section to the second section.

The first protruding element and the second protruding element can be configured in accordance with an embodiment of a protruding element described above. For example, a protruding element can be configured as a portion of a layer that extends outward from the main body of the shield structure. The protruding element can be formed integrally with the layer or attached separately. Examples of protruding elements can include tabs, flanges, hooks, or other extending features.

A protruding element may be characterized by an extension of a layer of the plurality of layers outward from a main body or plane of the shield structure. The protruding element can protrude in any direction relative to the surface of the shield structure.

The first protruding element and the second protruding element can be configured to be mechanically connected or joined to dedicated sections or parts of the shield structure. It is conceivable that the mechanical connection between the protruding elements (i. e. the first protruding element and the second protruding element) and the dedicated sections or parts of the shield structure is permanent or reversible. Examples of suitable mechanical connections can include bolting, screwing, riveting, welding, glueing, and/or interlocking of complementary structural features.

According to an embodiment, the first protruding element and the second protruding element are configured to be mechanically connected to each other. This may allow a connection point between the first section and the second section to be arranged in an easily accessible position, while potentially reducing or preventing any deflection of the magnetic flux in unfavourable directions.

A protruding element may favourably enable the shield structure to be mounted to a support structure, while also providing means to mechanically connect two or more sections of the shield structure.

According to a further embodiment of the inventive shield structure, the plurality of layers is formed in such a way to provide at least one receiving space configured to accommodate the component. The plurality of layers may enclose the component along a circumferential direction of the component when the component is arranged within the receiving space in a shielding position.

A receiving space can be configured as a designated area or volume within the shield structure that is shaped and sized to accommodate a component or set of components that require shielding from magnetic fields. The at least one receiving space can be formed by the plurality of layers of magnetic shielding material.

According to an embodiment, the at least one receiving space is confined by the plurality of layers in at least two spatial directions, at least three spatial directions, at least four spatial directions, or at least five spatial directions.

In a further embodiment, the plurality of layers may be arranged in such a way to circumferentially enclose the at least one receiving space along a primary axis or longitudinal axis defined by the receiving space. It is conceivable that the at least one receiving space formed by the plurality of layers is shaped to surround or encompass the component around its perimeter or outer surface when the component is arranged within the receiving space in the shielding position. The at least one receiving space may favourably provide shielding coverage from multiple directions.

A shielding position may refer to a position of the component relative to the plurality of layers of the shield structure that allows for the component to be shielded in an intended manner from a magnetic field surrounding the shield structure. For example, arranging the component in the shielding position may involve accommodating the component within the at least one receiving space in such a way, that the component is arranged within a volume confined by the outer dimensions of the shield structure.

The at least one receiving space may comprise a shape that conforms to or closely matches an outer profile or shape of the component. For example, for a cylindrical component like a motor shaft, the at least one receiving space can be configured as a cylindrical cavity. For a rectangular component, the at least one receiving space can be configured as a rectangular cavity. The shape of the at least one receiving space can be customized based on the geometry of the component to be shielded. The at least one receiving space can be configured to provide a close fit around the component while providing at least one opening allowing for an insertion and/or removal of the component. A shield structure providing a close fit around the component may favourably comprise a small footprint.

The plurality of layers may be bent or folded to form the at least one receiving space. It is also conceivable that the shield structure comprises two or more sections according to an embodiment described above, which are configured to be mechanically connected to form the at least one receiving space.

The at least one receiving space may be configured to facilitate heat dissipation or cooling of the component. For example, the at least one receiving space may form an air duct allowing for air or other fluids to pass through the at least one receiving space. This can be particularly beneficial for components that generate heat during operation, such as motors or electronic devices.

A shield structure comprising at least one receiving space according to an embodiment described above may favourably comprise a small footprint, while providing efficient shielding from multiple spatial directions. In providing a plurality of layers of a magnetic shielding material bent or folded in such a way to form one or more receiving spaces, manufacturing costs of the shield structure may favourably be reduced in comparison to shield structures comprising welded sections.

In a further embodiment of the inventive shield structure, the magnetic shielding material comprises a ferromagnetic material.

A ferromagnetic material can be defined as a substance that exhibits strong magnetic properties when exposed to an external magnetic field. Ferromagnetic materials can be characterized by their ability to be magnetized and retain their magnetization even after the external field is removed. Examples of ferromagnetic materials can include, but are not limited to, iron, nickel, cobalt, and their alloys. The ferromagnetic material may have a high magnetic permeability (or low magnetic reluctance), which enables it to concentrate or conduct magnetic flux and provide effective shielding against magnetic fields. The low magnetic reluctance of the material of the plurality of layers can combine synergistically with the high magnetic reluctance provided by one or more gaps, but also spacing elements, between the plurality of layers to divert or redirect the magnetic flux along a trajectory defined by the shape of the plurality of layers.

The ferromagnetic material can be configured in various forms for use in the shield structure. Due to its low magnetic reluctance, a ferromagnetic material can be configured as a particularly thin sheet metal, which can easily be punched, cut, folded and/or bent to form the plurality of layers of the shield structure.

One or more layers of the plurality of layers of the shield structure can be made of iron or other ferromagnetic materials with low magnetic reluctance. Iron can be an effective choice due to its high magnetic permeability and relatively low cost. The shield structure can also comprise one or more layers or sheets of mild steel. Mild steel is a type of carbon steel with a relatively low carbon content, typically between 0.05% and 0.25% by weight. Mild steel can offer a good balance of magnetic properties, formability, and cost-effectiveness for magnetic shielding applications. The use of multiple layers can enhance the shielding effectiveness compared to a single thick layer.

The use of ferromagnetic materials can offer several advantages. For example, the ferromagnetic material can redirect magnetic flux (or magnetic field lines), effectively reducing the magnetic field strength within the shielded area or receiving space of the shield structure. The plurality of layers of ferromagnetic material interrupted by one or more gaps can create discontinuities in the magnetic field path, enhancing the shielding effect compared to conventional shielding approaches. Additionally, the ability to use relatively thin sheets of material can result in a lightweight and cost-effective shielding solution compared to solid or single-layer designs.

The invention relates in a second aspect to a magnetic resonance device. The magnetic resonance device is configured to acquire magnetic resonance data from an object positioned in an imaging region of the magnetic resonance device. The magnetic resonance device comprises a magnet arrangement configured to generate a magnetic field. The magnetic resonance device further comprises a shield structure according to an embodiment described above. The shield structure is configured to shield at least one component of the magnetic resonance device from the magnetic field.

The magnetic resonance device can be configured to acquire magnetic resonance image data, particularly diagnostic magnetic resonance image data, from the object positioned within the imaging region. The object can be an inanimate object or a patient, particularly a human or an animal.

The magnetic resonance device can represent a closed bore scanner. A closed bore scanner can comprise a substantially cylindrical bore circumferentially enclosing the imaging region. The closed bore scanner can comprise a magnet arrangement or main magnet including one or more solenoidal superconducting magnet coils. The one or more solenoidal superconducting magnet coils may be configured to circumferentially encompass the imaging region along an axial direction or an axis of rotational symmetry of the cylindrical bore. The one or more superconducting magnet coils can comprise a superconducting wire having a negligible electrical resistance at or below a superconducting temperature. A direction of a main magnetic field generated by the one or more superconducting magnet coils can be oriented substantially in parallel to a direction of access of the object to the imaging region and/or the axial direction of the cylindrical bore.

In other embodiments, the magnetic resonance device can be configured as an open bore scanner, a C-type scanner, a single-sided scanner, or the like.

The magnetic resonance device can comprise further components required for a proper operation of the magnetic resonance device. For example, the magnetic resonance device can comprise an outer vacuum chamber, a magnet support structure, and/or one or more thermal radiation shields. In certain embodiments, the magnetic resonance device can comprise one or more cryogen vessels and/or one or more thermal buffers.

The magnet arrangement can be configured to provide a magnetic field suitable for magnetic resonance imaging applications. Particularly, the magnet arrangement can be configured to provide a static or main magnetic field within the imaging region of the magnetic resonance device. For example, the magnet arrangement can be configured to generate a main magnetic field having a maximum magnetic field strength between 0.1 and 12 Tesla, preferably about 0.5 Tesla, 1.5 Tesla, 3 Tesla, 5 Tesla, 7 Tesla, or 9.4 Tesla.

In some embodiments, the shield structure may be configured to enclose the magnetic resonance device and the at least one component may be arranged outside a volume enclosed by the shield structure. For example, the shield structure may be configured as a shield structure of an examination room comprising a magnetic resonance device. In other embodiments, the shield structure may be arranged within the magnetic field generated by the magnet arrangement of the magnetic resonance device and configured to at least partially enclose the at least one component.

The at least one component may represent a component of the magnetic resonance device. In other embodiments, the at least one component may represent a component not belonging to the magnetic resonance device. For example, the at least one component may represent a component outside of an examination room housing the magnetic resonance device. The shield structure can be configured to shield the at least one component from the magnetic field generated by the magnet arrangement of the magnetic resonance device.

The shield structure can comprise a plurality of layers of a magnetic shielding material arranged in a stacked configuration. The shield structure can comprise a gap separating adjacent layers of the plurality of layers. The shield structure can comprise a spacing element configured to maintain the gap between the adjacent layers. The shield structure may be configured according to an embodiment described above.

A layer of the shield structure may comprise at least one protruding element protruding from a surface of the shield structure. The protruding element may be configured to mechanically connect the shield structure to a support structure of the magnetic resonance device, such as a cryostat structure, a turret, an outer vacuum chamber, and/or any other suitable support structure.

The shield structure can comprise two or more sections that can be mechanically connected to form an enclosure. A first section can comprise a first protruding element, and a second section can comprise a second protruding element. The first protruding element and the second protruding element can be configured to attach the first section to the second section. The first protruding element and/or the second protruding element can also be configured to attach the shield structure to a support structure of the magnetic resonance device.

The plurality of layers of the shield structure may be formed in such a way to provide at least one receiving space configured to accommodate the component to be shielded. The receiving space can be shaped to confine the component in at least three spatial directions or at least four spatial directions. The receiving space may be shaped to enclose the component along its circumference or circumferential direction.

The shield structure of the magnetic resonance device can be configured to shield various components from the magnetic field generated by the magnetic resonance device. For example, the shield structure can be configured to shield a motor, a motor shaft of a cryocooler, a fan, a loudspeaker, a motor of a patient table, a switch, an electronic circuit, an amplifier, a transformer, an inductor, a sensor, and/or other components of the magnetic resonance device. However, the shield structure can also be applied to shield components in particle accelerators, fusion reactors, magnetic levitation systems, and the like.

The shield structure of the magnetic resonance device may favourably provide effective shielding of sensitive components from the magnetic fields present in magnetic resonance imaging environments. The stacked configuration of the shield structure can enhance the shielding effectiveness compared to solid or single-layer designs, but also reduce weight and/or costs. Furthermore, the modular design with detachable layers and/or sections can facilitate installation and maintenance of shielded components. The inventive magnetic resonance device shares the advantages associated with the previously described embodiments of the inventive shield structure.

According to an embodiment of the inventive magnetic resonance device, the at least one component is arranged in such a way that a primary axis of the at least one component is arranged at a non-zero angle with respect to a direction of the magnetic field.

A primary axis can be defined as a principal axis extending along the length of an object or component. For example, the primary axis may represent an axis of symmetry, an axis along a main dimension, or a longitudinal axis of the at least one component. The primary axis of the at least one component may be understood as a main axis along which the at least one component extends or operates. The primary axis of the at least one component may coincide with a primary axis or longitudinal axis of the shielding structure configured to shield the at least one component.

A non-zero angle can be defined as any angle that is not equal to zero degrees or 180 degrees. According to an embodiment, the magnetic resonance device is configured in such a way that an absolute angle between the direction of the magnetic field and the primary axis of the at least one component exceeds 5°, 10°, 15°, 20°, 25°, 30°, or 35°. The absolute angle between the direction of the magnetic field and the primary axis of the at least one component can vary depending on the specific component and its function within the magnetic resonance device. For instance, the angle can range from a slight deviation from parallel (e.g., a few degrees) to a perpendicular orientation (90 degrees) or any angle in between. An optimal angle can be determined based on factors such as the component's sensitivity to magnetic fields, its proximity to a geometric centre of the magnet arrangement and/or the local strength of the magnetic field at the location of the component, its operational requirements, and the overall design constraints of the magnetic resonance device. A non-zero angle between the direction of the magnetic field and the primary axis of the at least one component (and thus the shield structure) may favourably improve shielding effectiveness and overall performance of the shield structure in comparison to conventional shielding arrangements.

The direction of the magnetic field can be understood as a local orientation of the magnetic field lines generated by the magnet arrangement at a spatial position or a geometric centre of the at least one component of the magnetic resonance device. For example, the local orientation of the magnetic field at a position of the at least one component may refer to the specific direction of magnetic field lines at the spatial location where the at least one component is situated.

The at least one component can be configured as any element or part of the magnetic resonance device mentioned above.

The shield structure may be arranged in a similar orientation to the at least one component. For instance, a longitudinal axis of the shield structure may be arranged substantially parallel to or coincide with the longitudinal axis of the at least one component. The shield structure may represent a custom-shaped enclosure for the at least one component.

An angled arrangement of the at least one component and the shield structure with respect to the direction of the magnetic field may favourably allow for magnetic flux to be more effectively redirected along the plurality of layers of the shield structure, potentially enhancing the overall shielding effectiveness. By optimizing the orientation of the at least one component and the shield structure relative to the direction of the magnetic field, costs and/or weight of the magnetic resonance device may favourably be reduced, while maintaining or improving shielding effectiveness in comparison to prior art solutions.

In a further embodiment of the inventive magnetic resonance device, the at least one component comprises at least one of: a motor; a fan; an electronic circuit; an amplifier; a transformer; a loudspeaker; a cable; or a switch.

A motor can be configured as an electromechanical device that converts electrical energy into mechanical energy. The motor can comprise a rotor and a stator. The rotor can be configured as the rotating part of the motor, while the stator can be configured as the stationary part. The motor can be configured to operate based on various principles, such as (electro-)magnetic induction, electrostatic forces, or piezoelectric effects. Examples of motors that can be used in a magnetic resonance device include direct current (DC) motors and alternating current (AC) motors. For example, the motor can be configured as a stepper motor, a servo motor, or a brushless DC motor. The motor can be configured to drive various components of the magnetic resonance device, such as a patient table, a fan, or a cryocooler.

A fan can be configured as a mechanical device that creates a flow of air or gas. The fan can comprise blades or vanes attached to a hub, which can be configured to rotate around an axis of the fan. The fan can be configured to operate based on various principles, such as axial flow, centrifugal flow, or cross flow. Examples of fans that can be used in a magnetic resonance device include axial fans, centrifugal fans, or mixed flow fans. The fan can be configured to provide cooling or ventilation for various components of the magnetic resonance device, such as electronic components (e. g. an amplifier, a transformer, an inductor), parts of a gradient system and/or a radio frequency system, or a run-down load.

A switch can be configured as a mechanical and/or electrical component that can control (e. g. interrupt or divert) the flow of electric current in an electric circuit. The switch can be configured to operate based on various principles, such as mechanical actuation, electromagnetic actuation, or solid-state switching. The switch can be configured to control various functions of the magnetic resonance device, such as power distribution, signal routing, or safety interlocks.

The shield structure can be configured to shield the at least one component from the magnetic field generated by the magnet arrangement. The shield structure can be configured to reduce (electro-)magnetic interference that may affect the operation of the at least one component during operation of the magnetic resonance device.

By shielding one or more of the components mentioned above, a proper functionality of these components can favourably be maintained even in the presence of strong magnetic fields. Moreover, a shielding structure according to the invention may favourably provide improved shielding efficiency compared to prior art solutions, enabling the placement of such components in locations that may otherwise be subject to magnetic field interference, potentially leading to a more compact and efficient design of the magnetic resonance device.

Embodiments of the invention are illustrated in the drawings and will be described in more detail below. The same reference numerals are used for the same features in different figures. The figures show:
- Fig. 1: shows a schematic representation of an embodiment of a magnetic resonance device according to the invention.
- Fig. 2: shows an isometric view of an embodiment of a shield structure according to the invention.
- Fig. 3: shows a schematic representation of an embodiment of a shield structure according to the invention.
- Fig. 4: shows a section of an embodiment of a shield structure according to the invention.
- Fig. 5: shows a section of an embodiment of a shield structure according to the invention.
- Fig. 6: shows a section of an embodiment of a shield structure according to the invention.
- Fig. 7: shows a section of an embodiment of a shield structure according to the invention.
- Fig. 8: shows a section of an embodiment of a shield structure according to the invention.
- Fig. 9: shows an isometric view of an embodiment of a shield structure according to the invention.
- Fig. 10: shows an isometric view of an embodiment of a shield structure according to the invention.
- Fig. 11: shows an isometric view of an embodiment of an inventive shield structure accommodating a plurality of fans.
- Fig. 12: shows a schematic representation of an embodiment of a shield structure according to the invention.
- Fig. 13: shows an isometric view of an embodiment of a shield structure according to the invention.
- Fig. 14: shows a schematic representation of an embodiment of a shield structure according to the invention.

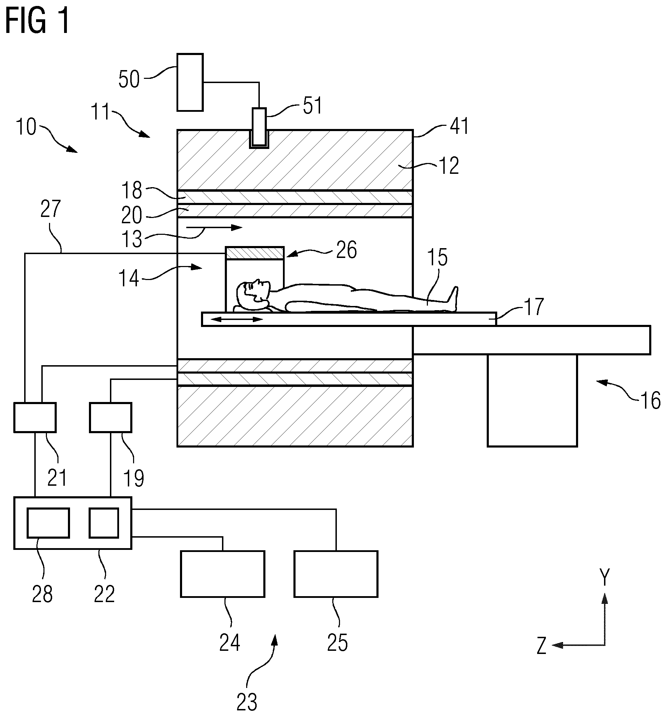

Fig. 1 shows an embodiment of a magnetic resonance device 10 according to the invention. The magnetic resonance device 10 comprises a static field magnet or main magnet 12 including one or more magnet coils configured to generate a homogenous, static magnetic field 13 (B0 field). The static magnetic field 13 permeates an imaging region 14 configured to receive an imaging object, such as a patient 15. The imaging region 14 may correspond to an inner volume of a patient bore configured to accommodate a patient 15 during a magnetic resonance measurement. In the depicted embodiment, the imaging region 14 is encompassed by the main magnet 12 in a circumferential direction. The main magnet 12 forms a part of a magnet arrangement 11 of the magnetic resonance device 10.

The magnetic resonance device 10 may comprise a patient positioning device 16 configured to transport the patient 15 into the imaging region 14. Particularly, the patient positioning device 16 may be configured to transport a diagnostically relevant body region of the patient 15 into an imaging volume or isocentre (not shown) of the magnetic resonance device 10. The magnet arrangement 11 and other components of the magnetic resonance device 10 may be concealed in a housing (not shown).

The magnetic resonance device 10 may comprise a gradient system including one or more gradient coils 18. The one or more gradient coils 18 may be configured to generate gradient magnetic fields in different, preferably orthogonally oriented, spatial directions. The gradient magnetic fields can be used for spatial encoding of magnetic resonance signals or magnetic resonance data acquired during a magnetic resonance measurement. The one or more gradient coils 18 can be activated or controlled via an appropriate control signal provided by a gradient control unit 19.

The magnetic resonance device 10 may further comprise radiofrequency system including an integrated radiofrequency antenna 20 (e. g. a body coil). The radiofrequency antenna 20 may be activated or controlled via a radiofrequency control unit 21. The radiofrequency control unit 21 may be configured to control the radiofrequency antenna 20 to generate a high frequency magnetic field and emit radiofrequency excitation pulses into the imaging region 14. The gradient coils 18 and the radiofrequency antenna 20 may be connected to a respective gradient control unit 19 and a radiofrequency control unit 21 via signal connections 27.

The magnetic resonance device 10 may further comprise a local coil 26. The local coil 26 may be positioned on or in proximity to a diagnostically relevant body region of the patient 15. The local coil 26 may be configured to emit radiofrequency excitation pulses into the patient 15 and/or receive magnetic resonance signals from the patient 15. It is conceivable, that the local coil 26 is controlled via the radiofrequency control unit 21.

Preferably, the magnetic resonance device 10 comprises a control unit 22 configured to control the magnetic resonance device 10. The control unit 22 may comprise a processing unit 28 configured to process acquired magnetic resonance signals and reconstruct magnetic resonance images based on the acquired magnetic resonance signals. The processing unit 28 may also be configured to process input from a user of the magnetic resonance device 10 and/or provide an output to the user. For this purpose, the processing unit 28 and/or the control unit 22 can be connected to a display unit 24 and an input unit 25 via a suitable signal connection. For a preparation of a magnetic resonance measurement, preparatory information, such as imaging parameters or patient information, can be provided to the user via the display unit 24. The input unit 25 may be configured to receive information and/or imaging parameters from the user. The display unit 24 and the input unit 25 may form a part of a user interface 23 configured to enable the user to interact with the magnetic resonance device 10.

In the example depicted in Fig. 1, the magnetic resonance device 10 comprises a cryocooler 50 configured to cool the main magnet 12, but also other components of the magnet arrangement 11 and/or the magnetic resonance device 10. The cryocooler 50 may comprise a compressor (not shown) supplying pressurized gas or cryogen to the cryocooler 50. The cryocooler 50 may utilize various thermodynamic cycles, such as the Gifford-McMahon cycle, the pulse tube cycle, or the Stirling cycle, to achieve cryogenic temperatures. The cryocooler 50 may include a cold head 51 comprising one or more cooling stages. In case the cold head 51 comprises two or more cooling stages, each cooling stage may be configured to provide cooling at a different temperature level.

According to an embodiment, a second stage of the cold head 51 is thermally connected to the main magnet 12, while a first stage of the cold head 51 is thermally connected to other components of the magnet arrangement 11, such as a thermal radiation shield, a further thermal radiation shield, a shield tube, a buffer unit, or the like (not shown).

According to an embodiment, the cold head 51 is thermally and mechanically connected to the main magnet 12 and/or other components of the magnet arrangement 11 via a solid thermal conductor (not shown). However, it is also conceivable that a cooling fluid which is cooled by the cold head 51 or an external source is circulated through cooling loops (not shown) connected to the main magnet 12 and/or other components of the magnet arrangement 11.

The magnetic resonance device 10 may comprise further components and/or functions which are common in magnetic resonance devices. The general operation of a magnetic resonance device is known to those skilled in the art, so a more detailed description is omitted.

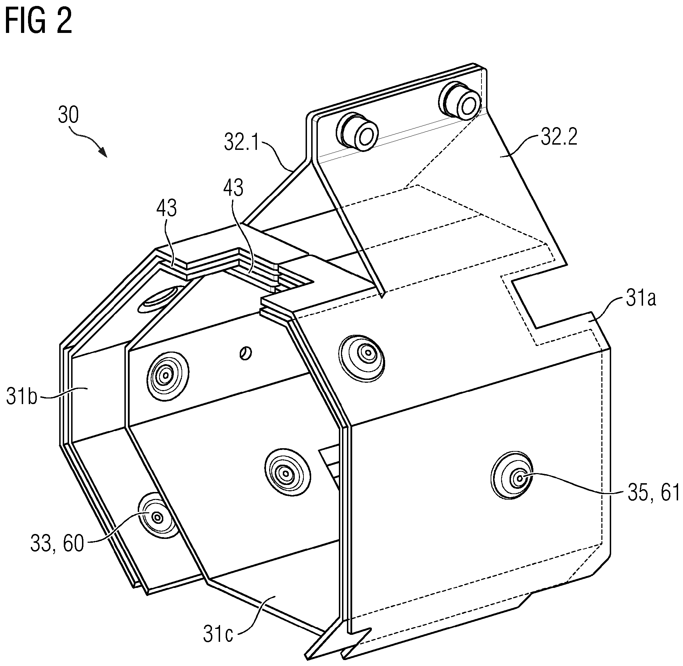

Fig. 2 shows a schematic representation of an embodiment of a shield structure 30. The shield structure 30 is configured to shield a component from a magnetic field. The shield structure 30 comprises a plurality of layers 31 of a magnetic shielding material arranged in a stacked configuration.

In the depicted embodiment, the shield structure 30 comprises three layers 31a, 31b, and 31c (31a-c). The layers 31a-c are arranged in a concentric manner. The layers 31a-c of the shield structure 30 are separated by gaps 43. The thickness of the layers 31a-c can be, for example, between 0.5 mm and 5 mm, preferably 1 mm to 3 mm. Similarly, the gap 43 between adjacent layers 31 can be, for example, between 0.5 mm and 5 mm, preferably 1 mm to 3 mm.

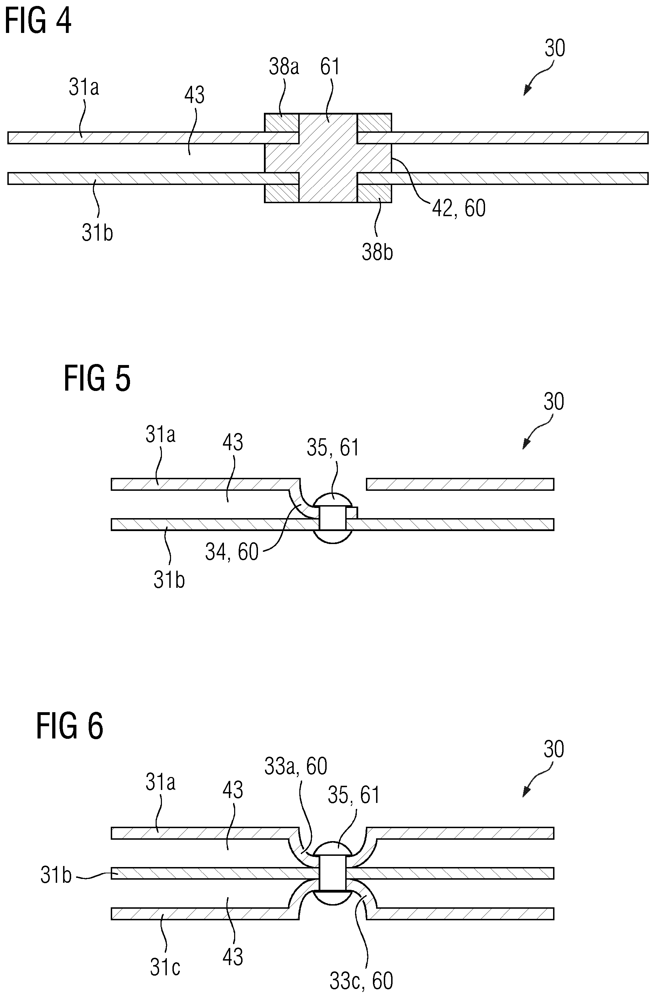

The shield structure 30 can comprise one or more spacing elements 60 configured to maintain the gaps 43 between the layers 31a-c. In the depicted embodiment, the spacing elements 60 are configured as dimples 33. The dimples 33 can be formed on at least one layer of the plurality of layers 31. For example, the dimples 33 can be provided on surfaces of the layer 31a and the layer 31c (see Fig. 6), but also on a surface of the layer 31b (see Fig. 2). The dimples 33 are configured to maintain the spacing or gaps 43 between the layers 31a-c.

According to an embodiment, the shield structure 30 comprises one or more connecting elements 61 configured to mechanically connect the layers 31a-c. In the example depicted in Fig. 2, the connecting elements 61 are configured as rivets 35. The rivets 35 are configured to secure the layers 31a-c together at various points, providing structural integrity to the shield structure 30. The rivets 35 can be arranged in corresponding holes or openings provided in the layers 31a-c. In the example depicted in Fig. 2, the rivets 35 are arranged in the dimples 33 to prevent the heads of the rivets 35 from protruding from a surface of the layers 31a-c.

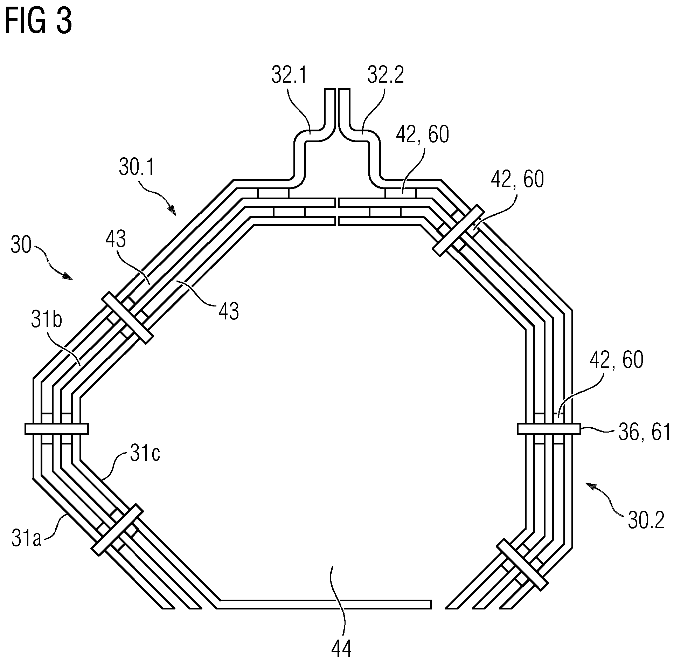

The shield structure 30 depicted in Fig. 2 comprises two protruding elements 32.1 and 32.2. The protruding elements 32.1 and 32.2 can be configured to allow for two halves or sections 30.1 and 30.2 (see Fig. 3) of the shield structure 30 to be attached to one another. Alternatively or additionally, the protruding elements 32.1 and 32.2 can serve as connection points or mounting features for the shield structure 30. For example, the protruding elements 32.1 and 32.2 can be configured to attach or mount the shield structure 30 to a support structure (not shown).

The layers 31a-c of the shield structure 30 can comprise or consist of punched or (laser-)cut folded sheet metal. The layers 31a-c may comprise or consist of a ferromagnetic material, such as iron, steel or mild steel. In certain embodiments, the shield structure 30 comprises two or more layers 31 of sheet mild steel.

In an embodiment, the shield structure 30 can comprise a first section 30.1 and a second section 30.2 (see Fig. 3) configured to be mechanically connected to form an enclosure for the component to be shielded. The protruding elements 32.1 and 32.2 can be configured to attach the first section 30.1 to the second section 30.2, thereby forming the complete shield structure 30.

The shield structure 30 depicted in Fig. 2 can be configured to provide shielding for a component of a magnetic resonance device, such as a motor of a cold head. The stacked configuration or laminated structure of the shield structure 30 comprising multiple layers 31a-c separated by gaps 43 may provide enhanced shielding performance compared to solid or single-layer designs.

Fig. 3 shows a schematic representation of an embodiment of a shield structure 30 according to the invention. The shield structure 30 comprises a plurality of layers 31 of a magnetic shielding material arranged in a stacked configuration. In the depicted example, the shield structure 30 comprises a first layer 31a, a second layer 31b, and a third layer 31c which are arranged concentrically to create a laminated structure.

The shield structure 30 comprises gaps 43 separating adjacent layers 31 of the plurality of layers 31. In the present embodiment, a first gap is provided between the first layer 31a and the second layer 31b, and a second gap is provided between the second layer 31b and the third layer 31c. The gaps 43 contribute to the overall shielding performance of the shield structure 30 by impeding the magnetic flux from directly passing from an outer layer 31a to an inner layer 31c and redirection the magnetic flux along the material of the layers 31a-c.

A spacing element 60 can be configured to maintain the gaps 43 between adjacent layers 31. In the example depicted in Fig. 3, the spacing elements 60 are configured as spacers 42 arranged between adjacent layers 31, e. g. between the first layer 31a and the second layer 31b, but also between the second layer 31b and the third layer 31c. The spacers 42 can be configured to maintain a predetermined separation between the layers 31a-c.

The shield structure 30 can comprise a connecting element 61 configured to mechanically connect two or more of the layers 31a-c. In the present embodiment, the shield structure 30 comprises a plurality of connecting elements 61 configured as bolts 36. Each bolt 36 passes through corresponding holes in the three layers 31a-c and the spacers 42. For example, the bolts 36 can be configured to provide a force-locking connection with the spacers 42 and/or be secured with nuts (see Fig. 4).

In the depicted embodiment, the layers 31a-c of the shield structure 30 are formed in such a way to provide a receiving space 44, which is configured to accommodate a component that requires magnetic shielding. The receiving space 44 can be shaped in such a way to confine the component to be shielded from at least three spatial directions, at least four spatial directions, or at least five spatial directions.

The shield structure 30 can comprise one or more sections configured to be mechanically connected to form an enclosure for the component to be shielded. In the present embodiment, the shield structure 30 comprises a first section 30.1 and a second section 30.2. The first section 30.1 comprises a first protruding element 32.1, and the second section 30.2 comprises a second protruding element 32.2. The first protruding element 32.1 is formed integrally with the first layer 31a of the first section 30.1, and the second protruding element 32.2 is formed integrally with the first layer 31a of the second section 30.2. The protruding elements 32.1 and 32.2 are configured to mechanically connect or attach the two sections 30.1 and 30.2 of the shield structure 30. Additionally or alternatively, the protruding elements 32.1 and 32.2 can be configured to mechanically connect the shield structure 30 to a support structure of a device comprising the shield structure 30.

The layers 31a-c of the shield structure 30 can be made of iron or other ferromagnetic material with low magnetic reluctance. The gap 43 between adjacent layers 31 can be at least partially filled with plastic or any material that provides structural stability. In certain embodiments, the gaps 43 between the plurality of layers 31a-c may comprise a fluid or a vacuum.

Fig. 4 shows a schematic representation of a section of an embodiment of a shield structure 30 according to the invention. The shield structure 30 comprises a plurality of layers 31 of a magnetic shielding material arranged in a stacked configuration.

In the embodiment shown in Fig. 4, the shield structure 30 comprises two adjacent layers 31a and 31b. A gap 43 is provided between the adjacent layers 31a and 31b. The shield structure 30 comprises a spacing element 60 configured to maintain the gap 43 between the adjacent layers 31. The spacing element 60 is configured as a spacer 42, e. g. a pin spacer, a cantilever pin, a custom machined pin, or a sleeve placed on a bolt. At least a section of the spacing element 60 is arranged between the adjacent layers 31a and 31b.

The spacing element 60 can be made of a material with high magnetic reluctance. In certain embodiments, the spacing element 60 comprises or consists of a material having a low magnetic reluctance.

The shield structure 30 can comprise a connecting element 61 configured to mechanically connect the adjacent layers 31a and 31b. In the embodiment shown in Fig. 4, the connecting element 61 can be configured as a bolt or a pin. The bolt or pin can be configured to pass through corresponding holes provided in the layers 31a and 31b and the spacer 42. The connecting element 61 can be secured using a first nut 38a on one side of the plurality of layers 31 and a second nut 38b on the opposite side.

The gap 43 between adjacent layers 31a and 31b can comprise a vacuum or a fluid. In some embodiments, the gap 43 between the adjacent layers 31 may at least be partially filled with a resin or other spacing element according to a previously described embodiment.

The shield structure 30 may allow for an addition of further layers 31 depending on specific shielding and/or cost requirements. This modular design allows for flexibility in application and optimization of shielding performance.

Fig. 5 shows a schematic representation of a section of a further embodiment of a shield structure 30 according to the invention. In the depicted example, the shield structure 30 comprises two adjacent layers 31a and 31b, which are arranged substantially parallel to each other with a gap 43 provided between them.

The shield structure 30 can comprise a spacing element 60 configured to maintain the gap 43 between the adjacent layers 31. In the embodiment depicted in Fig. 5, the spacing element 60 is configured as a louver 34. The louver 34 comprises a bent protrusion formed on the surface of the layer 31a. Particularly, the louver 34 protrudes from a surface of the first layer 31a facing the second layer 31b. The louver 34 can be configured to maintain the spacing between the first layer 31a and the second layer 31b, creating a consistent gap 43 throughout the shield structure 30.

The shield structure 30 can comprise a connecting element 61 configured to mechanically connect the adjacent layers 31a and 31b. In the depicted example, the connecting element 61 is configured as a rivet 35. The rivet 35 can be arranged in corresponding holes or openings provided in the louver 34 of the first layer 31a and in the second layer 31b. The rivet 35 can be configured to attach the first layer 31a to the second layer 31b, ensuring the structural integrity of the shield structure 30.

The shield structure 30 can comprise a plurality of rivets 35 and louvers 34, which can be arranged at regular or irregular intervals across the shield structure 30. The louvers 34 and rivets 35 can be placed at strategic points to facilitate assembly and/or disassembly of the shield structure 30.

Fig. 6 shows a schematic representation of a section of a further embodiment of a shield structure 30 according to the invention. In the depicted example, the shield structure 30 includes three layers 31a, 31b, and 31c (31a-c) of a magnetic shielding material arranged in a stacked configuration. The three layers 31a-c are separated by gaps 43. For example, a gap 43 is provided between a first layer 31a and a second layer 31b, and between the second layer 31b and a third layer 31c.

The shield structure 30 can comprise a spacing element 60 configured to maintain a gap 43 between adjacent layers 31 (e. g. the first layer 31a and the second layer 31b, and/or the second layer 31b and the third layer 31c). In the embodiment shown in Fig. 6, the spacing element 60 is configured as a dimple 33 formed on at least one layer 31. Specifically, a first dimple 33a can be provided on the first layer 31a, protruding inward towards the second layer 31b. A second dimple 33c can be provided on the third layer 31c, also protruding inward towards the second layer 31b. The first dimple 33a and the second dimple 33c can be configured to maintain a predetermined spacing between the layers 31a-c.

The shield structure 30 can further comprise a connecting element 61 configured to mechanically connect adjacent layers 31. As shown in Fig. 6, the connecting element 61 can be configured as a rivet 35 passing through all three layers 31a-c, providing a mechanical connection to hold the layers 31a-c together. The rivet 35 can be positioned in alignment with the first dimple 33a and the second dimple 33c. For example, the rivet 35 can pass through corresponding holes or openings in the surfaces of the layers 31a-c at the positions of the dimples 33a and 33c.

The dimples 33a and 33c, acting as spacing elements 60, can allow for predetermined gaps 43 to be maintained between the layers 31a-c, which can contribute to the shielding effectiveness of the shield structure 30.

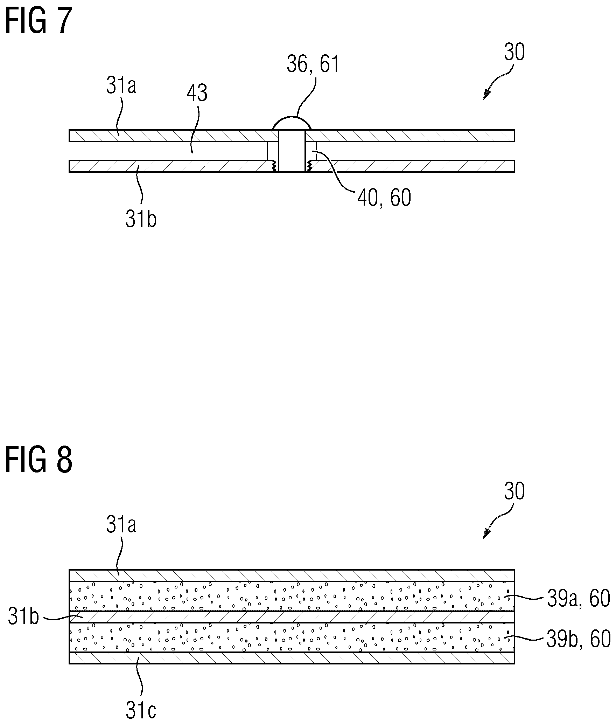

Fig. 7 shows a schematic representation of a section of an embodiment of a shield structure 30-according to the invention. The shield structure 30 can be configured to shield a component from a magnetic field. In the illustrated embodiment, the shield structure 30 comprises a first layer 31a and a second layer 31b. The layers 31a and 31b are separated by a gap 43. The gap 43 between the adjacent layers 31 can be at least partially filled with a fluid or a material that provides structural stability to the layers 31a and 31b.

The shield structure 30 can comprise a spacing element 60 configured to maintain the gap 43 between the adjacent layers 31. In the embodiment shown in Fig. 7, the spacing element 60 is configured as a self-clinching insert 40 arranged between the first layer 31a and the second layer 31b. The self-clinching insert 40 can comprise a cylindrical body that fits within the space between the layers 31a and 31b.

The shield structure 30 can comprise a connecting element 61 configured to mechanically connect the adjacent layers 31. In the embodiment depicted in Fig. 7, the connecting element 61 is configured as a bolt 36. The bolt 36 can be configured to pass through corresponding holes in the self-clinching insert 40 and in the adjacent layers 31a and 31b. The connecting element 61 can alternatively be configured as a rivet, a pin, or a screw.

The self-clinching insert 40 can be configured to accommodate the bolt 36 and mechanically engage with the second layer 31b, but also the first layer 31a, when the bolt 36 is correctly inserted.

Fig. 8 shows a schematic representation of a section of an embodiment of a shield structure 30 according to the invention. In the depicted embodiment, the shield structure 30 comprises an outer layer 31a, a middle layer 31b, and an inner layer 31c. The layers 31a-c are arranged in a stacked configuration, creating a laminated structure.

The shield structure 30 can comprise a spacing element 60 configured to maintain a gap 43 between adjacent layers 31 of the plurality of layers 31. In the present embodiment, the spacing element 60 is configured as a spacer arranged between at least two layers 31 of the plurality of layers 31. The spacing element 60 can comprise a material having a high magnetic reluctance. For example, the shield structure 30 can comprise a first resin layer 39a arranged between the outer layer 31a and the middle layer 31b, and a second resin layer 39b arranged between the middle layer 31b and the inner layer 31c. These resin layers 39a and 39b can be configured to maintain the separation or spacing between the layers 31a-c.

To provide a laminated structure as depicted in Fig. 8, the shield structure 30 can be submersed in a resin or filled with resin via a conduit. During the application of the resin, the gaps 43 between the layers 31a-c can be maintained by retrievable or permanent spacers (e. g. a spacing element 60 according to a previously describe embodiment). The shield structure 30 can be placed in a container or mould, which can be filled with resin. For example, the shield structure 30 can be submersed in resin, which can then flow into the spaces or gaps 43 between the layers 31a-c. In another example, the shield structure 30 can be enclosed by or wrapped in a membrane or a shell that prevents the resin from leaking. The resin can then be poured or filled into the gaps 43 between the layers 31a-c in a controlled manner, e.g. by means of a dedicated supply line.

The resin layers 39a and 39b can provide a consistent spacing between the layers 31a-c, allowing for an improved magnetic shielding efficiency compared to a single thick layer.

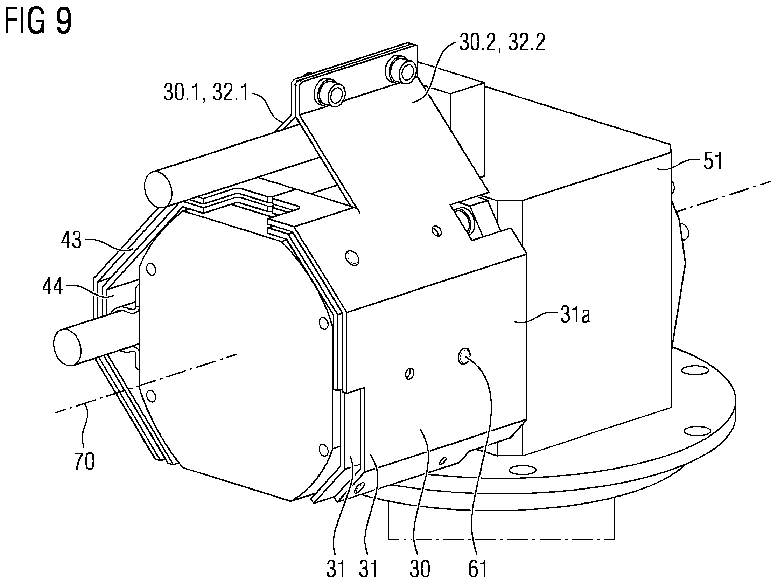

Fig. 9 shows a schematic representation of an embodiment of a shield structure 30 according to the invention. In the depicted example, the shield structure 30 is configured to enclose or surround a motor shaft of a cold head 51 for magnetic shielding purposes.

The shield structure 30 comprises multiple layers 31 arranged in a stacked configuration. The shield structure 30 may be configured in accordance with the embodiment depicted in Fig. 2 and/or Fig. 3. The layers 31 are formed in such a way to provide a receiving space 44 configured to accommodate the motor shaft of the cold head 51. The receiving space 44 may be shaped in such a way to circumferentially enclose at least a section of the motor shaft of the cold head 51 along its primary axis or longitudinal axis 70. For example, the plurality of layers 31 may enclose the motor shaft along a circumferential direction of the motor shaft when the motor shaft is arranged within the receiving space 44 in a shielding position as depicted in Fig. 9.

In the depicted embodiment, the motor shaft of the cold head 51 is arranged within the receiving space 44 of the shield structure 30. The cold head 51 can be a part of a cryogenic cooling system, such as a cryocooler 50 (see Fig. 1), commonly used in applications such as magnetic resonance imaging.

The shield structure 30 can comprise spacing elements (not shown) configured to maintain gaps 43 between adjacent layers 31. The spacing elements can include, for example, dimples, louvers, spacers, or self-clinching inserts. Additionally, the shield structure 30 can comprise connecting elements 61 configured to mechanically connect the adjacent layers 31. These connecting elements can include, for example, rivets, pins, screws, or bolts.

In the present example, the shield structure 30 comprises a first section 30.1 and a second section 30.2 configured to be mechanically connected to form an enclosure for the motor shaft of the cold head 51. Outer layers 31 of the first section 30.1 and the second section 30.2 comprise protruding elements 32.1 and 32.2 protruding from a surface of the shield structure 30. The protruding elements 32.1 and 32.2 can be configured to mechanically connect the shield structure 30 to a support structure (not shown), such as a support frame or a support element of a magnetic resonance device 10. Alternatively or additionally, the protruding elements 32.1 and 32.2 can be configured to mechanically connect the first section 30.1 to the second section 30.2.

In a magnetic resonance device 10 (see Fig. 1), the at least one component to be shielded can be arranged in such a way that a primary axis or longitudinal axis 70 of the at least one component and/or the shield structure 30 is arranged at a non-zero angle with respect to a main direction of the magnetic field. This arrangement can enhance the shielding effectiveness of the shield structure 30.

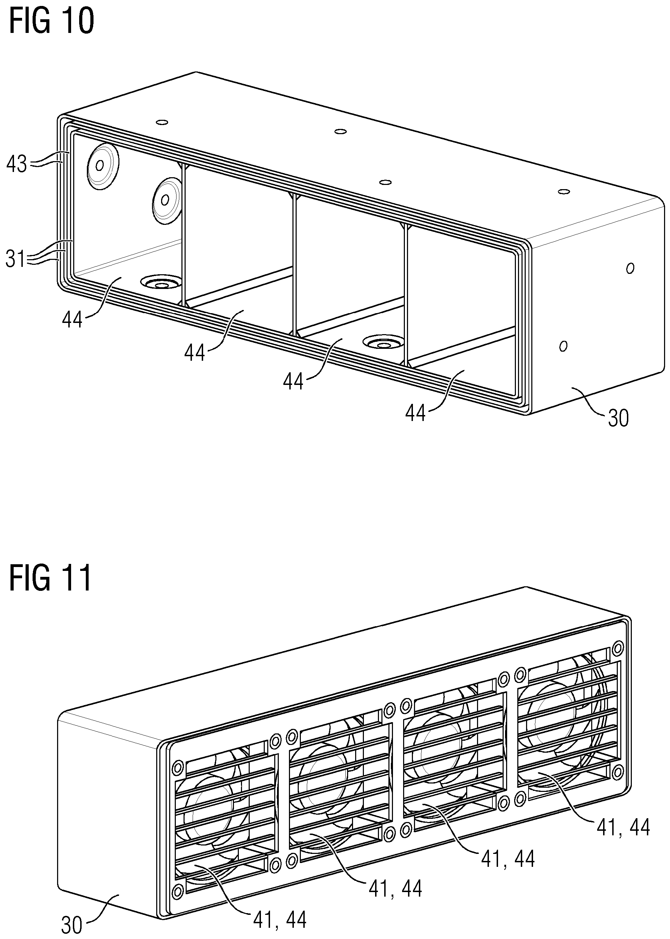

Fig. 10 shows a further embodiment of a shield structure 30 according to the invention. In the depicted example, the shield structure 30 is configured as a rectangular box comprising a plurality of receiving spaces 44. The shield structure 30 comprises an open front, providing access to the plurality of receiving spaces 44. Furthermore, the shield structure 30 comprises multiple layers 31 which are separated by gaps 43. The layers 31 form the walls of the shield structure 30, with the front side open to enable access to the receiving spaces 44. The layers 31 of the shield structure 30 can be attached to each other according to an embodiment described above. The shield structure 30 features a layered or stacked configuration in accordance with a previously described embodiment.

In the illustrated embodiment, the layers 31 of the shield structure 30 are formed in such a way to provide the receiving spaces 44. These receiving spaces 44 are distributed along the length of the shield structure 30 and can be visible through the open front. The receiving spaces 44 can be configured to accommodate components or equipment that require shielding, such as a motor, a fan, an amplifier, a transformer, an electronic circuit, a loudspeaker, a cable, a switch, and the like.

The shield structure 30 can be used in a magnetic resonance device 10. The magnetic resonance device 10 can include a magnet arrangement 11 configured to generate a magnetic field. The shield structure 30 can be configured to shield at least one component of the magnetic resonance device 10 from the magnetic field. This shielding can help protect sensitive components from interference caused by the strong magnetic fields used in magnetic resonance imaging.

Fig. 11 shows another representation of the embodiment of the shield structure 30 depicted in Fig. 10. In the illustrated example, the shield structure 30 accommodates a plurality of fans 41 in the receiving spaces 44. The receiving spaces 44 are shaped in such a way to circumferentially enclose each fan 41 along its primary or longitudinal direction. The front side and the back side (not shown) of the shield structure 30 comprise openings to allow for air to be transported by the fans 41. Thus, the receiving spaces 44 of the shield structure 30 may act as air ducts for the air moved by the fans 41. The shield structure 30 comprises a front panel covering the fans 41. The front panel can comprise slots configured to allow for air to flow through the front panel.

In other embodiments, the front panel can comprise a cooling circuit including pipes for a cooling fluid. The pipes can be arranged in a grid pattern similar to the front panel depicted in Fig. 11. Thus, an airflow provided via the fans 41 can pass over a heat exchange surface of the cooling circuit to cool a fluid circulated within the pipes or tubes of the cooling circuit.

The shield structure 30 can be configured to provide (electro-)magnetic shielding to the fans 41 and/or fan motors, while also providing an air duct for the air transported or driven by the fan 41. Thus, the shield structure 30 may favourably provide both electromagnetic interference protection and temperature control in a single unit. The fans 41 may be configured to actively cool a run-down load of a magnetic resonance device 10.

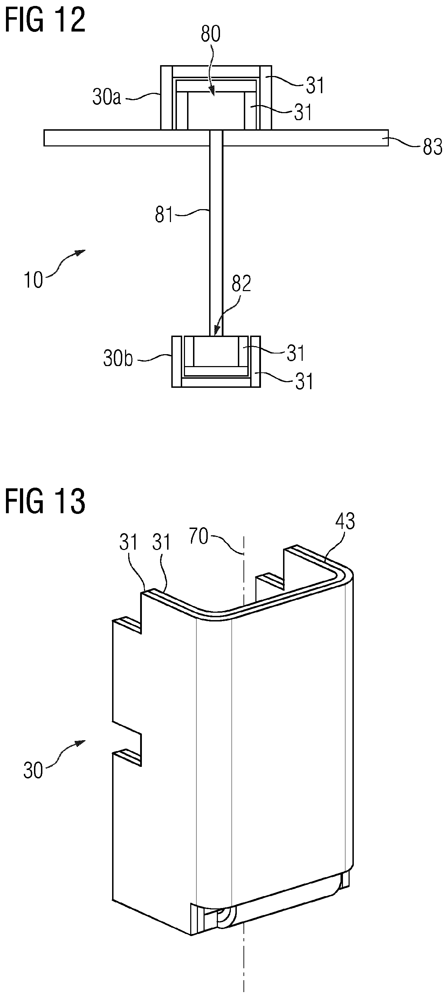

Fig. 12 shows a section of an inventive magnetic resonance device 10 comprising two shield structures 30a and 30b. In the depicted example, the shield structure 30a is configured to shield a motor 80 (e. g. a stepper motor) from the magnetic field generated by the magnetic resonance device 10. The motor 80 and the shield structure 30 are mechanically supported by a support structure 83 of the magnetic resonance device 10, e. g. a support frame or a turret. The motor 80 is mechanically connected to a mechanical switch 82 via a shaft 81. The motor 80 is configured to operate the mechanical switch 82 via driving components incorporated into the shaft 81.

The switch 82 may be configured as a mechanical switch operated by the motor 80. The switch 82 may be configured to control electrical current to other components of the magnetic resonance device 10. In one embodiment, the switch 82 may comprise a contact made of a bismuth alloy, such as a bismuth-tin alloy, a bismuth-indium alloy, or a bismuth-indium-tin alloy. Bismuth alloys may be used as electrical contacts for switches and connectors due to their low electrical resistivity and good wear resistance.

The shield structure 30b is configured to shield the switch 82 from the magnetic field generated by the magnetic resonance device 10. The shield structure 30a is configured to enclose the motor 80 from multiple directions. Likewise, the shield structure 30b is configured to enclose the switch 82 from multiple directions. For example, the shield structures 30a and 30b may be configured to confine the motor 80 and the switch 82 in at least three spatial directions, at least four spatial directions, at least 5 spatial directions, or six spatial directions, respectively.

In the depicted example, each of the shield structures 30a and 30b comprises two layers 31. According to an embodiment, the motor 80, the switch 82 and the shield structures 30a and 30b are arranged in such a way that the longitudinal axes or primary axes of the motor 80, the switch 82 and the shield structures 30a and 30b are arranged at a non-zero angle with respect to a main direction of the magnetic field (not shown).

Fig. 13 shows a further representation of an embodiment of a shield structure 30 according to the invention. In the depicted embodiment, the shield structure 30 is configured to accommodate a power supply unit (not shown) and shield the power supply unit from a magnetic field generated by a magnetic resonance device 10. The shield structure 30 comprises two adjacent layers 31 of a magnetic shielding material which are separated by a gap 43. The gap 43 may comprise a fluid, a vacuum, or a solid material having a high magnetic reluctance. For example, the gap 43 may at least be partially occupied by a spacer 42 or a resin.

The shield structure 30 depicted in Fig. 13 is configured to confine the power supply unit in four spatial directions, e. g. a first direction oriented in parallel to the z-direction, a second direction oriented in parallel to the x-direction as well as a third direction and a fourth direction oriented opposite to each other and parallel to the y-direction.

According to an embodiment, the power supply unit and the shield structure 30 are arranged in such a way that the longitudinal axes 70 or primary axes of the power supply unit and the shield structure 30 are arranged at a non-zero angle with respect to a main direction of a magnetic field generated by the device or system (not shown) comprising the shield structure 30.

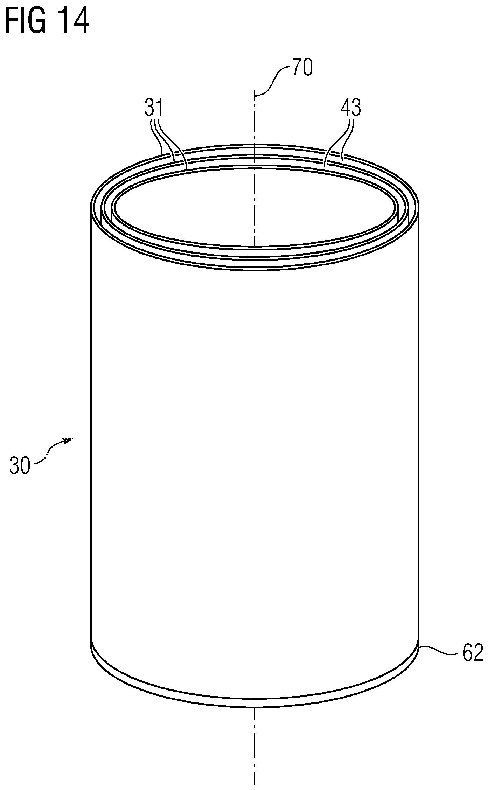

Fig. 14 shows a schematic representation of another embodiment of a shield structure 30 according to the invention. In the depicted embodiment, the shield structure 30 comprises a plurality of tube-shaped layers 31 which are separated by gaps 43. The tube-shaped layers 31 are concentrically arranged or nestled inside of each other in such a way, that layers 31 having a larger diameter circumferentially enclose layers 31 having a smaller diameter along the primary axis or longitudinal axis 70 of the shield structure 30.

The shield structure 30 depicted in Fig. 14 may comprise one or more end caps 62 configured to cover the openings of the tube-shaped layers 31. The one or more end caps 62 may act as a spacing element configured to maintain the gaps 43 between the tube-shaped layers 31. For example, the one or more end caps 62 may be glued, soldered and/or welded onto end sections of the tube-shaped layers 31. However, the one or more end caps 62 may also comprise a dedicated ridge, flange or edge configured to mechanically engage with the gaps 43. For example, the ridges or edges of the one or more end cap 62 may be plugged or inserted into the gaps 43, mechanically connecting the end cap 62 and the tube-shaped layers 31 via a force-locking and/or a form-locking mechanical connection. An end cap 62 as described above may favourably avoid connecting elements from passing through the plurality of tube-shaped layers 31 in a radial direction, potentially preventing magnetic flux from passing through the plurality of tube-shaped layers 31 in a radial direction and improving the shielding effect of the shield structure 30.

The end cap 62 may also be attached to the tube-shaped layers 31 via connecting elements (not shown) according to a previously described embodiment. According to an embodiment, the connecting elements may be oriented parallel to the axis 70 of the shield structure 30. For example, the connecting elements may be configured to mechanically engage with the tube-shaped layers 31 and/or spacing elements arranged within the gaps 43 between the tube-shaped layers 31. The ridges or edges of the one or more end caps 62, but also the connecting elements and/or spacing elements, may be configured to maintain the spacing or gaps 43 between the tube-shaped layers 31.

The one or more end caps 62 may comprise or consist of a material having a high magnetic reluctance. For example, the material of the one or more end caps 62 may correspond to a material of the tube-shaped layers 31. A volume enclosed by the layer 31 with the smallest diameter may correspond to a receiving space configured to accommodate a component to be shielded from a magnetic field. The one or more end caps 62 may be configured to enclose a resin, a liquid, or air between the plurality of tube-shaped layers 31. The one or more end caps 62 may also provide a seal configured to maintain a vacuum between the plurality of tube-shaped layers 31.

This design of the shield structure 30 illustrated in the above-described Figures may favourably allow for effective magnetic shielding while maintaining a lightweight and easily manufacturable form.

The schematic representations depicted in the figures do not represent any scale or size relationships.

The methods and devices described in detail above are merely exemplary embodiments which can be modified in a variety of ways by those skilled in the art without departing from the scope of the invention. Particularly, individual embodiments may be extended by or combined with features of other embodiments if not explicitly stated otherwise.

Furthermore, the use of the indefinite articles "a" or "an" does not preclude that individual features in question can also be present multiple times. Likewise, the terms "unit" and "element" do not preclude that the components in question consist of several interacting sub-components which can also be spatially distributed if necessary.

In the context of the present application, the expression "based on" can be understood in particular in the sense of the expression "using". In particular, a formulation according to which a first feature is generated based on a second feature (alternatively: determined, determined, etc.) does not exclude the fact that the first feature can be generated based on a third feature (alternatively: determined, determined, etc.).

## Claims

1. A shield structure (30) for shielding a component from a magnetic field, the shield structure (30) comprising:
• a plurality of layers (31) of a magnetic shielding material arranged in a stacked configuration;
• a gap (43) separating adjacent layers (31) of the plurality of layers (31); and
• a spacing element (60) configured to maintain the gap (43) between the adjacent layers (31).

2. The shield structure (30) of claim 1, wherein the plurality of layers (31) comprises a first layer (31a), a second layer (31b), and a third layer (31c), wherein a first gap (34a) is provided between the first layer (31a) and the second layer (31b), and a second gap (34b) is provided between the second layer (31b) and the third layer (31c).

3. The shield structure (30) of claim 1 or 2, wherein the spacing element (60) comprises at least one of:
• a dimple (33) formed on at least one layer (31) of the plurality of layers (31);
• a louver (34) formed on at least one layer (31) of the plurality of layers (31);
• a spacer (42) arranged between at least two layers (31) of the plurality of layers (31); or
• a self-clinching insert (40) arranged between at least two layers (31) of the plurality of layers (31).

4. The shield structure (30) of any of claims 1 to 3, wherein the spacing element (60) comprises a material having a high magnetic reluctance.

5. The shield structure (30) of any of claims 1 to 4, wherein the shield structure (30) comprises a connecting element (61) configured to mechanically connect the adjacent layers (31).

6. The shield structure (30) of claim 5, wherein the connecting element (61) comprises at least one of:
• a rivet (35);
• a pin;
• a screw;
• or a bolt (36); and
wherein the connecting element (61) is configured to pass through corresponding holes in the spacing element (60) and in the adjacent layers (31) to mechanically connect the adjacent layers (31).

7. The shield structure (30) of any of claims 1 to 6, wherein the gap (43) between the adjacent layers (31) comprises a fluid or a vacuum.

8. The shield structure (30) of any of claims 1 to 7, wherein a layer (31) of the shield structure (30) comprises at least one protruding element (32) protruding from a surface of the shield structure (30), wherein the protruding element (32) is configured to mechanically connect the shield structure (30) to a support structure.

9. The shield structure (30) of any of claims 1 to 8, wherein the shield structure (30) comprises a first section (30.1) and a second section (30.2) configured to be mechanically connected to form an enclosure for the component to be shielded.

10. The shield structure (30) of claim 9, wherein a layer (31) of the first section (30.1) comprises a first protruding element (32.1), and a layer (31) of the second section (30.2) comprises a second protruding element (32.2), wherein the first protruding element (32.1) and the second protruding element (32.2) protrude from a surface of the shield structure (30), and wherein the first protruding element (32.1) and the second protruding element (32.2) are configured to attach the first section (30.1) to the second section (30.2).

11. The shield structure (30) of any of claims 1 to 10, wherein the plurality of layers (31) is formed in such a way to provide at least one receiving space (44) configured to accommodate the component, wherein the plurality of layers (31) encloses the component along a circumferential direction of the component when the component is arranged within the receiving space (44) in a shielding position.

12. The shield structure (30) of any of claims 1 to 11, wherein the magnetic shielding material comprises a ferromagnetic material.

13. A magnetic resonance device (10) configured to acquire magnetic resonance data from an object (15) positioned in an imaging region (14) of the magnetic resonance device (10), comprising:
• a magnet arrangement (11) configured to generate a magnetic field; and
• a shield structure (30) according to any of claims 1 to 12, wherein the shield structure (30) is configured to shield at least one component from the magnetic field.

14. The magnetic resonance device (10) of claim 13, wherein the at least one component is arranged in such a way that a primary axis (70) of the at least one component is arranged at a non-zero angle with respect to a direction of the magnetic field.

15. The magnetic resonance device (10) of claim 13 or 14, wherein the at least one component comprises at least one of: a motor; a fan (41); an electronic circuit; an amplifier; a transformer; a loudspeaker; a cable; or a switch.
